(19) Europäisches Patentamt
European Patent Office
Office européen des brevets

(11) **EP 3 114 767 B1**

(12) **EUROPÄISCHE PATENTSCHRIFT**

(45) Veröffentlichungstag und Bekanntmachung des Hinweises auf die Patenterteilung:
**13.04.2022 Patentblatt 2022/15**

(21) Anmeldenummer: **15709125.7**

(22) Anmeldetag: **26.02.2015**

(51) Internationale Patentklassifikation (IPC):
**H03K 3/0231** $^{(2006.01)}$   **H03B 5/20** $^{(2006.01)}$

(52) Gemeinsame Patentklassifikation (CPC):
**H03K 3/0231**

(86) Internationale Anmeldenummer:
**PCT/EP2015/054000**

(87) Internationale Veröffentlichungsnummer:
**WO 2015/132121 (11.09.2015 Gazette 2015/36)**

(54) **OSZILLATOR, SENDE-/EMPFANGSEINRICHTUNG FÜR EIN BUSSYSTEM UND VERFAHREN ZUR ERZEUGUNG EINER TAKTFREQUENZ MIT DEM OSZILLATOR**

OSCILLATOR, TRANSMITTER/RECEIVER FOR A SYSTEM WITH A BUS AND METHOD FOR GENERATING A CLOCK FREQUENCY WITH THE OSCILLATOR

OSCILLATEUR, TRANSMETTEUR/RECEPTEUR POUR UN SYSTEME AVEC BUS ET PROCEDE POUR GENERER UN SIGNAL D'HORLOGE AVEC L'OSCILLATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.03.2014 DE 102014204047**

(43) Veröffentlichungstag der Anmeldung:
**11.01.2017 Patentblatt 2017/02**

(73) Patentinhaber: **Robert Bosch GmbH
70442 Stuttgart (DE)**

(72) Erfinder:
• **PANNWITZ, Axel
01445 Radebeul (DE)**
• **HEHEMANN, Ingo
49170 Hagen am Teutoburger Wald (DE)**

(56) Entgegenhaltungen:
EP-A1- 1 280 024    WO-A1-2010/129927
WO-A1-2011/059322    DE-A1- 19 611 942
US-A1- 2010 164 638    US-B1- 7 474 163

**Beschreibung**

Die vorliegende Erfindung betrifft einen Oszillator und eine Sende-/Empfangseinrichtung für ein Bussystem, welche beispielsweise bei einer Teilnehmerstation für ein CAN-Bussystem als Zeitbasis für einen CAN-Transceiver für den Teilnetz-Betrieb zum Einsatz kommen können.

Stand der Technik

Für die Kommunikation zwischen zwei oder mehr Busteilnehmern, wie beispielsweise Sensor(en), Steuergerät(en), usw., hat das CAN-Bussystem eine weite Verbreitung gefunden. Beim CAN-Bussystem werden Nachrichten mittels des CAN-Protokolls übertragen, wie es in der CAN-Spezifikation in der ISO11898 beschrieben ist.

Zum Empfangen und Senden der Nachrichten im Bussystem findet in der Regel eine Sende-/Empfangseinrichtung Verwendung, die in Bezug auf CAN auch CAN-Transceiver genannt ist. Derartige Sende-/Empfangseinrichtungen werden bei CAN bei einigen Anwendungsfällen in neuerer Zeit als CAN-Transceiver für den Teilnetz-Betrieb ausgestaltet, der auch Partial-Networking-Transceiver genannt wird. Hierfür ist der CAN-Transceiver mit einer hochgenauen Zeitbasis auszustatten. Gefordert wird hierbei, dass die Frequenz- bzw. Zeittoleranz im Temperaturbereich von -40 °C bis 175 °C abhängig vom Jitter einen Wert zwischen +-1% bis +/- 1,6 % hat. Eine weitere erschwerende Anforderung an die Zeitbasis besteht darin, dass für den gesamten CAN-Transceiver im Empfangsmodus nur eine Stromaufnahme von < 150 μA gewünscht ist.

Eine Lösung dieses Problems könnte in der Verwendung eines Quarzes oder eines Keramikresonators als Zeitbasis liegen. Jedoch scheidet diese Lösung aus Kosten- oder Platzgründen für einen CAN-Transceiver aus.

US 7,474,163 B1 zeigt ein System und ein Verfahren für eine Auslöschung von Rauschen für einen Oszillator, welcher einen Komparator aufweist. Gemäß einer Ausführungsvariante ist an den positiven Anschluss des Komparators eine schaltbare Kapazität angeschlossen. Alternativ ist die schaltbare Kapazität gemäß einer weiteren Ausführungsvariante an den negativen Anschluss des Komparators angeschlossen.

Offenbarung der Erfindung

Daher ist es Aufgabe der vorliegenden Erfindung, einen Oszillator und eine Sende-/Empfangseinrichtung für ein Bussystem bereitzustellen, welche die zuvor genannten Probleme lösen. Insbesondere sollen ein Oszillator und eine Sende-/Empfangseinrichtung für ein Bussystem bereitgestellt werden, bei welchen kostengünstig im Empfangsmodus einer CAN- Sende-/Empfangseinrichtung (eines CAN-Transceivers) nur eine geringe Stromaufnahme, nämlich < 150 μA, erfolgt und eine hochgenaue Zeitbasis platzsparend bereitgestellt ist.

Die Aufgabe wird durch einen Oszillator zur Erzeugung einer Taktfrequenz mit den Merkmalen von Anspruch 1 gelöst.

Mit dem Oszillator kann eine kostengünstige und hochgenaue Zeitbasis mit sehr geringer Stromaufnahme bereitgestellt werden. Insbesondere werden die von einigen Anwendern geforderten Werte von bis zu +/- 1,0 % Frequenz- bzw. Zeittoleranz im Temperaturbereich von -40 °C bis 175 °C und Stromaufnahme von < 150 μA im Empfangsmodus eingehalten.

Vorteilhaft ist zudem, dass die Abmessungen des Oszillators so gering sind, dass er problemlos für eine Sende-/Empfangseinrichtung eines Bussystems, insbesondere für einen CAN-Transceiver für den Teilnetz-Betrieb einsetzbar ist Der Oszillator ist auch für den Einsatz in höher getakteten Systemen, wie beispielsweise CAN-HS, CAN-FD, usw., geeignet. Bei einem CAN-HS-Bussystem (HS = Hochgeschwindigkeit = Highspeed) ist eine Datenübertragungsrate von bis zu 500 kBit pro Sekunde (500 kbps) möglich. Bei einem CAN FD-Bussystem ist eine Datenübertragungsrate von größer 1 MBit pro Sekunde (1Mbps) möglich.

Vorteilhafte weitere Ausgestaltungen des Oszillators sind in den abhängigen Ansprüchen beschrieben.

Die schaltbare Kapazität ist in Reihe zu der frequenzbestimmenden Kapazität schaltbar, wobei der Komparator zur Erkennung der Schwellwertspannung einen MOS-Transistor aufweist.

Der Oszillator weist auch einen Schalter zum Schalten einer Spannungsquelle auf, um den Komparator mit einer Endspannung zu versorgen, wobei die Spannungsquelle parallel zu der frequenzbestimmenden Kapazität geschaltet ist, wenn der Schalter in einer Offsetphase geschlossen ist, und wobei die schaltbare Kapazität auf die Spannungsdifferenz Endspannung - Schwellwertspannung aufladbar ist, wenn der Schalter in der Offsetphase geschlossen ist.

Der Oszillator umfasst zudem einen Schalter zum Schalten der frequenzbestimmenden Kapazität des Zeitglieds in Reihe zu der schaltbaren Kapazität, wobei der Schalter in einer Offsetphase geöffnet und in einer Aufladephase der frequenzbestimmenden Kapazität geschlossen ist.

Darüber hinaus kann der Oszillator einen Schalter zum Kurzschließen der frequenzbestimmenden Kapazität aufweisen, wobei der Schalter in einer Offsetphase geschlossen und in einer Aufladephase der frequenzbestimmenden Kapazität geöffnet ist.

Der Oszillator kann auch einen Schalter zum Kurzschließen von Drain und Gate eines MOS-Transistors des Komparators aufweisen, welcher MOS-Transistor zur Erkennung der Schwellwertspannung dient, wobei der Schalter in einer Offsetphase geschlossen und in einer Aufladephase der frequenzbestimmenden Kapazität geöffnet ist.

Der Oszillator hat ein zweites Zeitglied, das wie das erste Zeitglied aufgebaut ist, und eine Logik, die zwischen das erste und zweite Zeitglied zum Ansteuern der schaltbaren Kapazität geschaltet ist.

Die zuvor genannte Aufgabe wird zudem durch eine Sende-/Empfangseinrichtung für eine Teilnehmerstation für ein Bussystem mit den Merkmalen von Anspruch 5 gelöst. Die Sende-/Empfangseinrichtung ist zum Senden oder Empfangen einer Nachricht von mindestens einer weiteren Teilnehmerstation des Bussystems über das Bussystem ausgestaltet, bei welchem Bussystem zumindest zeitweise ein exklusiver, kollisionsfreier Zugriff einer Teilnehmerstation auf einen Bus des Bussystems gewährleistet ist, wobei die Sende-/Empfangseinrichtung einen Oszillator mit einem ersten und zweiten Zeitglied und einer Logik aufweist, wobei das erste und zweite Zeitglied gleich aufgebaut sind und die Logik zwischen das erste und zweite Zeitglied geschaltet ist, und wobei der Oszillator wie zuvor beschrieben ausgestaltet sein kann.

Die zuvor beschriebene Teilnehmerstation kann Teil eines Bussystems sein, das einen Bus, und mindestens zwei Teilnehmerstationen aufweist, welche über den Bus derart miteinander verbunden sind, dass sie miteinander kommunizieren können. Hierbei weist mindestens eine der mindestens zwei Teilnehmerstationen eine zuvor beschriebene Sende-/Empfangseinrichtung auf.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Zeichnungen

Nachfolgend ist die Erfindung unter Bezugnahme auf die beiliegende Zeichnung und anhand von Ausführungsbeispielen näher beschrieben. Es zeigen:

Fig. 1 ein vereinfachtes Blockschaltbild eines Bussystems gemäß einem ersten Ausführungsbeispiel;
Fig. 2 ein elektrisches Schaltbild eines Oszillators für eine Sende-/Empfangseinrichtung des Bussystems gemäß dem ersten Ausführungsbeispiel;
Fig. 3 ein elektrisches Schaltbild eines Zeitglieds des Oszillators von Fig. 2;
Fig. 4 ein elektrisches Schaltbild eines Teils eines Oszillators für eine Sende-/Empfangseinrichtung des Bussystems gemäß einem zweiten Ausführungsbeispiel;
Fig. 5 das elektrische Schaltbild von Fig. 4 mit einer Schalterstellung in der Offsetphase; und
Fig. 6 das elektrische Schaltbild von Fig. 5 mit einer Schalterstellung in der Aufladephase einer Kapazität.

In den Figuren sind gleiche oder funktionsgleiche Elemente, sofern nichts anderes angegeben ist, mit denselben Bezugszeichen versehen.

Beschreibung der Ausführungsbeispiele

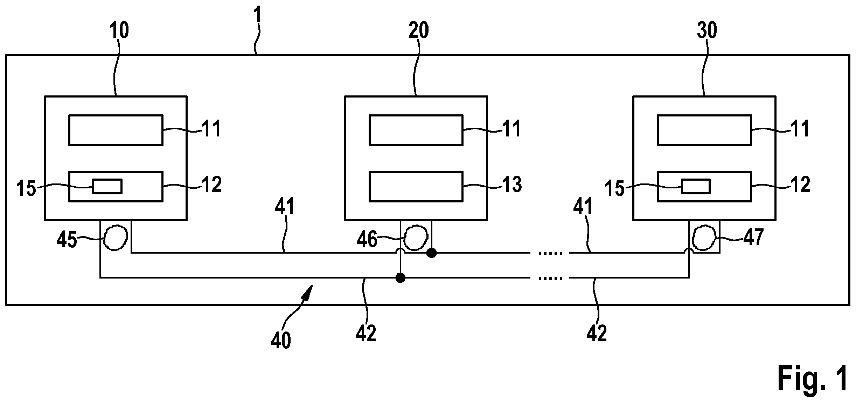

Fig. 1 zeigt ein Bussystem 1, das beispielsweise ein CAN-Bussystem, ein CAN-FD-Bussystem, usw., sein kann. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L genannt werden und dienen zur Einkopplung der dominanten Pegel im Sendezustand. Über den Bus 40 können Nachrichten 45, 46, 47 in der Form von Signalen zwischen den einzelnen Teilnehmerstationen 10, 20, 30 übertragen werden. Die Teilnehmerstationen 10, 20, 30 können beispielsweise Steuergeräte oder Anzeigevorrichtungen eines Kraftfahrzeugs sein.

Wie in Fig. 1 gezeigt, haben die Teilnehmerstationen 10, 30 jeweils eine Kommunikationssteuereinrichtung 11 und eine Sende-/Empfangseinrichtung 12. Die Sende-/Empfangseinrichtungen 12 umfassen jeweils einen Oszillator 15. Die Teilnehmerstation 20 hat dagegen eine Kommunikationssteuereinrichtung 11 und eine Sende-/Empfangseinrichtung 13. Die Sende-/Empfangseinrichtungen 12 der Teilnehmerstationen 10, 30 und die Sende-/Empfangseinrichtung 13 der Teilnehmerstation 20 sind jeweils direkt an den Bus 40 angeschlossen, auch wenn dies in Fig. 1 nicht dargestellt ist.

Die Kommunikationssteuereinrichtung 11 dient zur Steuerung einer Kommunikation der jeweiligen Teilnehmerstation 10, 20, 30 über den Bus 40 mit einer anderen Teilnehmerstation der an den Bus 40 angeschlossenen Teilnehmerstationen 10, 20, 30. Die Sende-/Empfangseinrichtung 12 dient zum Senden der Nachrichten 45, 47 in Form von Signalen und nutzt hierbei den Oszillator 15 als Zeitbasis, wie später noch ausführlicher beschrieben. Die Kommunikationssteuereinrichtung 11 kann wie ein herkömmlicher CAN-Controller ausgeführt sein. Die Sende-/Empfangseinrichtung 13 kann wie ein herkömmlicher CAN-Transceiver ausgeführt sein.

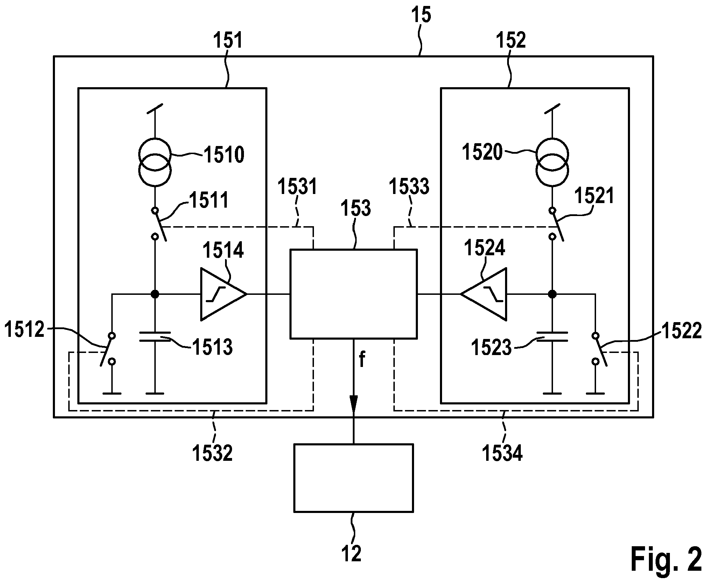

Fig. 2 zeigt den grundlegenden Aufbau des Oszillators 15, welcher ein erstes Zeitglied 151, ein zweites Zeitglied 152 und eine Logik 153 umfasst. Das erste Zeitglied 151 hat eine Stromquelle 1510, einen ersten Schalter 1511, einen zweiten Schalter 1512, eine Kapazität 1513 und einen Komparator 1514. Das zweite Zeitglied 152 hat eine Stromquelle 1520, einen ersten Schalter 1521, einen zweiten Schalter 1522, eine Kapazität 1523 und einen Komparator 1524. Das erste und zweite Zeitglied 151, 152 sind vorzugsweise identisch aufgebaut.

In Fig. 2 ist die Logik 153 in Bezug auf das erste Zeitglied 151 dazu ausgestaltet, den ersten Schalter 1511 über eine Verbindung 1531 zu schalten. Zudem kann die Logik 153 den zweiten Schalter 1512 über eine Verbindung 1532 schalten.

In Bezug auf das zweite Zeitglied 152 ist die Logik 1453 dazu ausgestaltet, den ersten Schalter 1521 über eine Verbindung 1533 zu schalten. Zudem kann die Logik 153 den zweiten Schalter 1522 über eine Verbindung 1534 schalten. Wie in Fig. 2 veranschaulicht, gibt die Logik 153 eine resultierende Frequenz f an die Sende-/Empfangseinrichtung 12 als Zeitbasis aus. Die Frequenz f kann auch als Schwingfrequenz oder Taktfrequenz des Oszillators 15 bezeichnet werden.

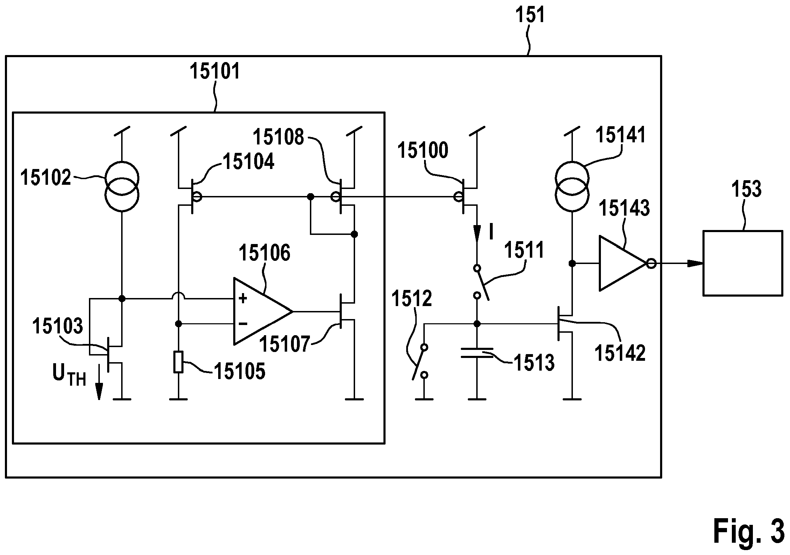

Bei dem Oszillator 15 wird die Schwingfrequenz oder Taktfrequenz durch die Aufladezeit der Kapazitäten 1513, 1523 bis zu einer bestimmten Spannungsschwelle bestimmt. Der Komparator 1514 dient zur Erkennung der Spannungsschwelle. Dies ist auch anhand von Fig. 3 näher erläutert.

Fig. 3 zeigt das erste Zeitglied 151 in Bezug auf die Stromquelle 1510 und den Komparator 1514 von Fig. 2 genauer. In Fig. 3 ist die Stromquelle 1510 von Fig. 2 ein MOS-Transistor 15100, der auch als ein MOSFET (Metall-Oxid-Semiconductor-Field-Effect-Transistor = Metall-Oxid-Halbleiter-Feldeffekttransistor) bezeichnet werden kann. Eine Gatespannung des MOS-Transistors 15100 wird von einer Regelschaltung 15101 bestimmt. Der Komparator 1514 von Fig. 2 umfasst gemäß Fig. 3 eine Stromquelle 15141 und einen MOS-Transistor 15142. Die Logik 153 wird von einem Treiber 15143 angesteuert.

Die Regelschaltung 15101 umfasst eine Konstantstromquelle 15102, einen MOS-Transistor 15103, der identisch zum MOS-Transistor 15142 ist, einen MOS-Transistor 15104, einen Widerstand 15105, einen Verstärker 15106, einen MOS-Transistor 15107 und einen MOS-Transistor 15108. Das Gate des MOS-Transistors 15108 ist sowohl mit dem Gate des MOS-Transistors 15100 als auch dem Gate des MOS-Transistors 15104 verbunden. Die MOS-Transistoren 15100, 15104, 15108 bilden einen Stromspiegel Der Widerstand 15105 ist an seiner einen Seite mit dem Drainanschluss des MOS-Transistors 15104 und dem invertierenden Anschluss des Verstärkers 15106 verbunden. An seiner anderen Seite ist der Widerstand 15105 geerdet. An den nichtinvertierenden Anschluss des Verstärkers 15106 sind der Drainanschluss und das Gate des MOS-Transistors 15103 sowie die Stromquelle 15102 angeschlossen.

Bei der Schaltung in Fig. 3 bestimmt sich der Strom I über den ersten Schalter 1511 als

$$ I \approx \frac{U_{TH}}{R} \qquad \ldots (1) $$

wobei $U_{TH}$ die Schwellwertspannung bzw. Thresholdspannung des MOS-Transistors 15103 und die Schaltschwelle des MOS-Transistors 15142 ist und R der Widerstandswert des Widerstands 15105 ist.

Die MOS-Transistoren 15100, 15104, 15108 können auch beliebige andere Halbleiterschalter oder Transistoren, wie beispielsweise Bipolartransistoren usw. sein.

Bei der Schaltung von Fig. 2 bzw. Fig. 3 wird beim ersten und zweiten Zeitglied 151, 152 durch Betätigen der Schalter 1511, 1512, 1521, 1522 abwechselnd die frequenzbestimmende Kapazität 1513 oder 1523 mit Hilfe eines Stroms von der jeweiligen Stromquelle 1510, 1520 bis zur Endspannung aufgeladen. Beim inaktiven Zeitglied 151 wird die Kapazität 1513 vollständig entladen. Beim inaktiven Zeitglied 152 wird die Kapazität 1523 vollständig entladen. Dadurch ergibt sich die vorbestimmte Frequenz f, welche als Zeitbasis für die Sende-/Empfangseinrichtung 12 dienen kann.

Der Oszillator 15 gemäß dem vorliegenden Ausführungsbeispiel hat somit einen einfachen MOS-Transistor als Komparator 1514. Bei dem Oszillator 15 wird die Kapazität 1513 von 0 V bis zur Schwellwertspannung bzw. Thresholdspannung $U_{TH}$ des MOS-Transistors 15103 aufgeladen. Die Schwellwertspannung bzw. Thresholdspannung $U_{TH}$ kann einen Wert von 0,4 bis 0,8 V haben. Vorteile dieses Prinzips sind geringe Stromaufnahme bei gleichzeitig geringer Schaltverzögerung. Die Regelschaltung 15101 erzeugt den Ladestrom der Kapazität 1513 in Abhängigkeit von der jeweiligen Schwellwertspannung $U_{TH}$.

Somit kann der Oszillator 15 die geforderte genaue, stromsparende, kostengünstige und platzsparende Zeitbasis für die Sende-/Empfangseinrichtung 12 liefern.

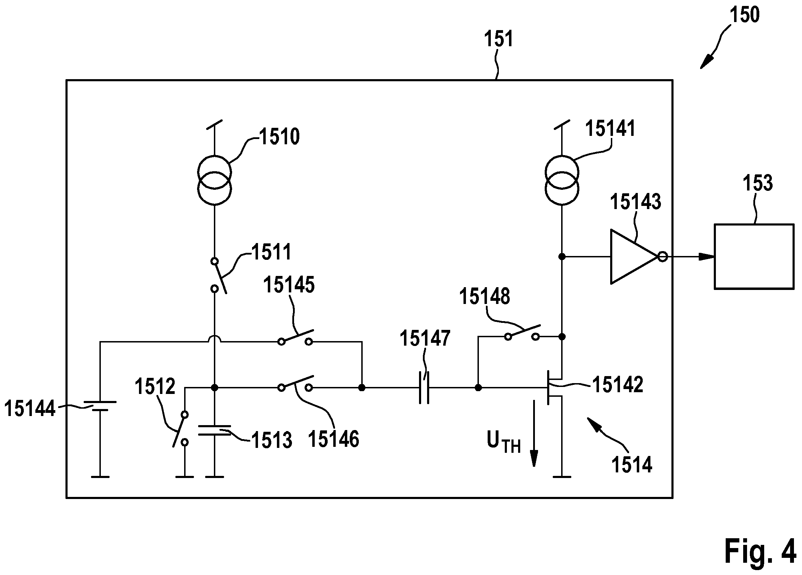

Fig. 4 zeigt das erste Zeitglied 151 und die Logik 153 eines Oszillators 150 gemäß einem zweiten Ausführungsbeispiel. Das zweite Zeitglied des Oszillators150 ist in Fig. 4 nicht dargestellt, ist jedoch auf die gleiche Weise aufgebaut wie das erste Zeitglied 151 und ist ebenfalls an die Logik 153 angeschlossen.

Bei dem Oszillator 150 gemäß dem vorliegenden Ausführungsbeispiel hat der Komparator 1514 eine Spannungsquelle 15144, welche eine Endspannung $U_{End}$ des Aufladevorgangs festlegt, einen ersten Schalter 15145, einen zweiten Schalter 15146, eine Kapazität 15147, und einen dritten Schalter 15148. Die Stromquelle 1510 in Fig. 4 ist derart ausgeführt, dass der Ladestrom aufgrund der festen Endspannung $U_{End}$ fest ist oder proportional zur Endspannung $U_{End}$ ist.

Die Elemente 15144 bis 15146 von Fig. 4 dienen zur Offsetkompensation. Der Übersichtlichkeit halber sind in Fig. 4 die Verbindungen zwischen der Logik 153 und den Schaltern 1511, 1512, 15145, 15146, 15148 nicht dargestellt.

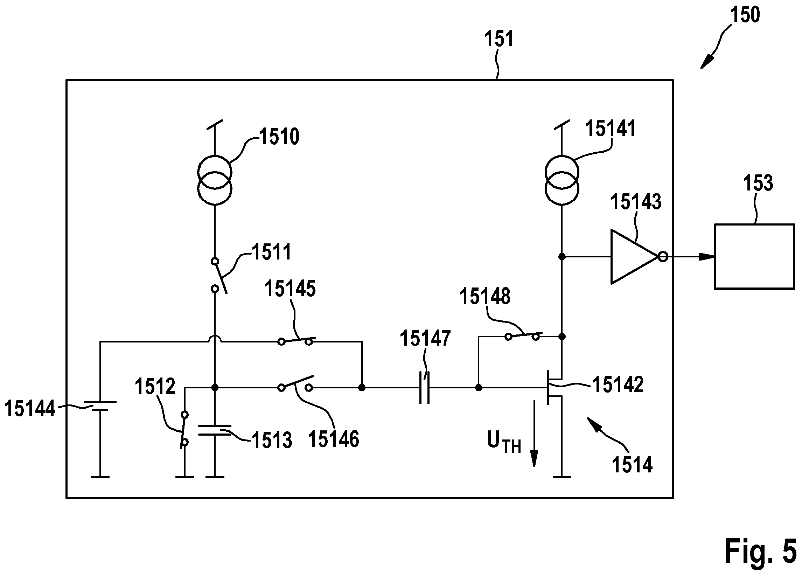

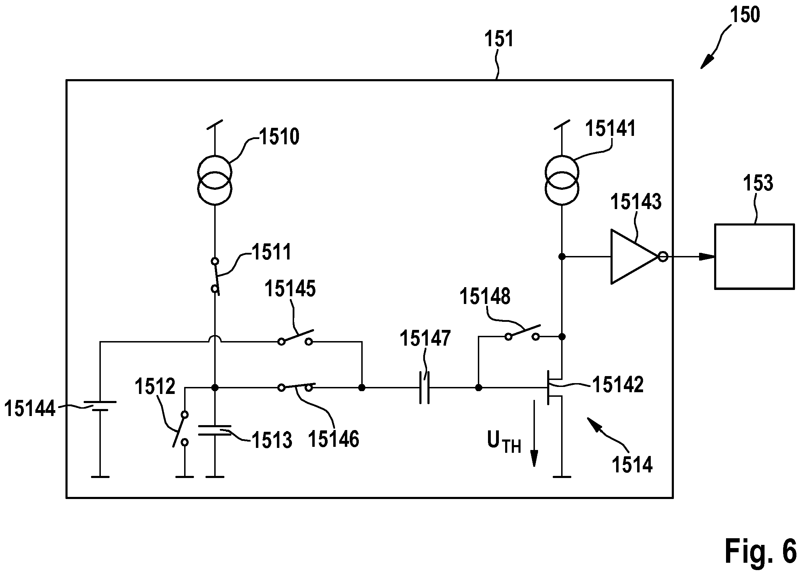

Wie in Fig. 5 gezeigt, sind die Schalter 1512, 15145, 15148 in einer Offsetphase geschlossen. Wie in Fig. 6 gezeigt, sind die Schalter 1511, 15146 während einer Aufladephase der frequenzbestimmenden Kapazität 1513 geschlossen. Die Endspannung $U_{End}$ an der Spannungsquelle 15144 ist eine frei wählbare Spannung, bis zu der die frequenzbestimmende Kapazität 1513 aufgeladen wird. Der Komparator 1514 ist somit ein Komparator mit geschalteter Kapazität oder SC-Komparator (SC = switched capacitor).

Auch bei der Schaltung von Fig. 4 bzw. Fig. 5 und Fig. 6 wird beim ersten Zeitglied 151 durch Betätigen der Schalter 1511, 1512 mit der Logik 153 abwechselnd die frequenzbestimmende Kapazität 1513 mit Hilfe eines Stroms von der Stromquelle 1510 bis zur Endspannung $U_{End}$ aufgeladen. Beim inaktiven ersten Zeitglied 151 wird die Kapazität 1513 vollständig entladen. Das zweite Zeitglied funktioniert gleichermaßen, wie bereits in Bezug auf das erste Ausführungsbeispiel beschrieben.

In der Offsetphase werden bei der Schaltung von Fig. 5 Drain und Gate des MOS-Transistors 15142 durch Schließen des dritten Schalters 15148 kurzgeschlossen. Damit bildet sich am Gate des MOS-Transistors 15142 die Schwellwertspannung $U_{TH}$ ab, die auch Thresholdspannung genannt wird. Gleichzeitig wird die Kapazität 15147, die auch als Reihenkapazität bezeichnet werden kann, zwischen das Gate des MOS-Transistors 15142 und die Spannungsquelle 15144 geschaltet. Diese Spannungsquelle 15144 bestimmt das Ende der späteren Aufladerampe für die frequenzbestimmende Kapazität 1513. Die Kapazität 15147 wird auf die Spannungsdifferenz UDiff aus Endspannung $U_{End}$ und Schwellwertspannung $U_{TH}$ aufgeladen, so dass gilt

$$U_{Diff} = U_{End} - U_{TH} \qquad \dots (2).$$

Nach der Offsetphase folgt die Aufladephase, die letztlich die Frequenz f des Oszillators 150 bestimmt und mit Fig. 6 dargestellt ist. Hierbei wird die Kapazität 15147 von der Endspannungsquelle auf die vollständig entladene frequenzbestimmende Kapazität 1513 geschaltet. Der Kurzschluss zwischen Drain und Gate des MOS-Transistors 15142 wird selbstverständlich vorher aufgehoben. Als Resultat liegt nun in diesem initialen Moment die negative Spannung aus der Kapazität 15147 am Gate des MOS-Transistors 15142 an. Die frequenzbestimmende Kapazität 1513 wird nun so lange aufgeladen, bis die Endspannung $U_{End}$ erreicht ist. Die Gatespannung des MOS-Transistors 15142 folgt der Spannung auf der frequenzbestimmenden Kapazität 1513 immer mit der Spannungsdifferenz, welche auf der Kapazität 15147 gespeichert ist. Bei Erreichen der Endspannung $U_{End}$ wird somit gleichzeitig die Schwellwertspannung $U_{TH}$ erreicht und der Komparator 1514 stoppt den Prozess.

Das zweite Zeitglied arbeitet auf die gleiche Weise wie das erste Zeitglied 151.

Auch bei dem Oszillator 150 wird somit die Schwingfrequenz oder Taktfrequenz durch die Aufladezeit der Kapazität 1513 des ersten Zeitglieds 151 bzw. der Kapazität 1523 des zweiten Zeitglieds 152 bis zu einer bestimmten Spannungsschwelle bestimmt, welche bei dem vorliegenden Ausführungsbeispiel die Schwellwertspannung $U_{TH}$ ist.

Mit der Schaltung von Fig. 4 bzw. Fig. 5 und Fig. 6 wird kompensiert, dass die Schwellwertspannung $U_{TH}$ des MOS-Transistors 15142 gering ist und Prozesstoleranzen unterworfen ist sowie stark im Temperaturbereich schwankt. Somit kann die temperaturabhängige Verzögerungszeit des Komparators 1514 welcher die Spannungsschwelle erkennt, als eine der Hauptfehlerquellen bei der Erzeugung einer genauen Taktfrequenz f ausgeschaltet werden. Zudem ist es bei dem Oszillator 150 nicht mehr erforderlich, den Ladestrom der Kapazität 1513 aufwändig mit einer Regelschaltung 15101 gemäß Fig. 3 zu erzeugen, die den Ladestrom der Kapazität 1513 in Abhängigkeit von der jeweiligen Schwellwertspannung $U_{TH}$ erzeugt. Da die Regelschaltung 15101 von Fig. 3 bei dem Oszillator 150 gemäß dem vorliegenden Ausführungsbeispiel nicht mehr benötigt wird, fällt die Regelschaltung 15101 gemäß Fig. 3 somit als weitere Fehlerquelle weg.

Mit der Schaltung von Fig. 4 bzw. Fig. 5 und Fig. 6 wird auch verhindert, dass aufgrund der geringen Spannungsanstiegsgeschwindigkeit auf der Kapazität 1513 die Schaltverzögerung des Oszillators 150 groß ist. Mit der Schaltung von Fig. 4 bzw. Fig. 5 und Fig. 6 wird der Spannungshub an der Kapazität 1513 größer, so dass die Thresholdspannung $U_{TH}$ des MOS-Transistors 15142 schneller überschritten und der Eingang des Treibers 15143 schneller nach unten gezogen.

Zusammengefasst sind bei dem Komparator 1514 die Verzögerungszeit und die Temperaturabhängigkeit gering. Der Oszillator 150 für die Sende-/Empfangseinrichtung 12 gemäß dem vorliegenden Ausführungsbeispiel hat eine besonders geringe Stromaufnahme, die unter den geforderten 150 μA liegt. Zudem liegt die Frequenz- bzw. Zeittoleranz im Temperaturbereich von -40 °C bis 175 °C unter einem Wert von +/- 1,6 %. Der Oszillator 150 ist zudem sehr kostengünstig und platzsparend realisierbar, da nur ein sehr geringer Flächenverbrauch auf dem Silizium besteht.

Somit hat der Oszillator 150 eine ähnlich geringer Stromaufnahme wie beispielsweise ein Quarz usw. Zudem hat der Oszillator 150 eine sehr gute Frequenzkonstanz im gewünschten Temperaturbereich von -40 °C bis 175 °C. Vorteile des Oszillators 150 gegenüber einem Quarz oder Keramikresonatoren liegen auch in der geringen mechanischen Empfindlichkeit, dem schnellen Anschwingen und den geringen Kosten des Oszillators 150. Quarze oder Keramikresonatoren fordern außerdem ein bis zwei Anschlüsse (Pins) an einer integrierten Schaltung (IC). Bei Quarzen oder Keramikresonatoren ist der Platz für die Verbindungslötaugen (Bondpads) schon größer als die vorgestellte Lösung, also der Oszillator 150.

Ansonsten ist das Bussystem gemäß dem vorliegenden Ausführungsbeispiel auf die gleiche Weise aufgebaut wie das Bussystem 1 gemäß dem ersten Ausführungsbeispiel.

Alle zuvor beschriebenen Ausgestaltungen des Oszillators 15, 150, der Sende-/Empfangseinrichtung 12, der Teilnehmerstationen 10, 20, 30, des Bussystems 1 gemäß dem ersten und zweiten Ausführungsbeispiel können einzeln oder in allen möglichen Kombinationen Verwendung finden. Zusätzlich sind insbesondere folgende Modifikationen denkbar.

Das zuvor beschriebene Bussystem 1 gemäß dem ersten und zweiten Ausführungsbeispiel ist anhand eines auf dem CAN-Protokoll basierenden Bussystems beschrieben. Das Bussystem 1 gemäß dem ersten und/oder zweiten Ausführungsbeispiel kann jedoch auch eine andere Art von Kommunikationsnetz sein. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30 auf die Busleitung 40 oder einen gemeinsamen Kanal der Busleitung 40 gewährleistet ist.

Das Bussystem 1 gemäß dem ersten und/oder zweiten Ausführungsbeispiel ist insbesondere ein CAN-Netzwerk oder ein CAN-HS-Netzwerk oder ein CAN FD-Netzwerk oder ein FlexRay-Netzwerk.

Die Anzahl und Anordnung der Teilnehmerstationen 10, 20, 30 in dem Bussystem 1 gemäß dem ersten und zweiten Ausführungsbeispiel ist beliebig. Insbesondere können auch nur Teilnehmerstationen 10 oder Teilnehmerstationen 30 in den Bussystemen 1 des ersten oder zweiten Ausführungsbeispiels vorhanden sein.

Die Funktionalität der zuvor beschriebenen Ausführungsbeispiele lässt sich in einem Transceiver bzw. einer Sende-/Empfangseinrichtung 12 bzw. Transceiver oder einem CAN-Transceiver oder einem Transceiver-Chipsatz oder einem CAN-Transceiver-Chipsatz oder auch in einer Kommunikationssteuereinrichtung 11, usw. umsetzen. Zusätzlich oder alternativ kann es in existierende Produkte integriert werden. Insbesondere ist es möglich, dass die betrachtete Funktionalität entweder im Transceiver als separater elektronischer Baustein (Chip) realisiert oder in einer integrierten Gesamtlösung, bei welchem nur ein elektronischer Baustein (Chip) vorhanden ist, eingebettet ist.

**Patentansprüche**

1. Oszillator (150) zur Erzeugung einer Taktfrequenz (f), mit

    einem Zeitglied (151), das eine frequenzbestimmende Kapazität (1513) zur Bestimmung der Frequenz der Taktfrequenz (f) und einen Komparator (1514) aufweist,
    wobei der Komparator (1514) zur Erkennung einer Schwellwertspannung ($U_{TH}$) ausgestaltet ist, bis zu welcher die frequenzbestimmende Kapazität (1513) aufzuladen ist, und
    wobei der Komparator (1514) eine schaltbare Kapazität (15147) zur Offsetkompensation aufweist,
    wobei der Komparator (1514) zur Erkennung der Schwellwertspannung ($U_{TH}$) einen MOS-Transistor (15142) aufweist, dessen Gate mit einem Ende der schaltbaren Kapazität (15147) verbunden ist,
    zudem mit einem Schalter (15145) zum Schalten einer Spannungsquelle (15144), um den Komparator (1514) mit einer Endspannung ($U_{End}$) zu versorgen,
    wobei die Spannungsquelle (15144) parallel zu der frequenzbestimmenden Kapazität (1513) geschaltet ist, wenn der Schalter (15145) in einer Offsetphase geschlossen ist, und
    zudem mit einem Schalter (15146) zum Schalten der frequenzbestimmenden Kapazität (1513) des Zeitglieds (151) in Reihe zu der schaltbaren Kapazität (15147),
    wobei der Schalter (15146) in einer Offsetphase geöffnet und in einer Aufladephase der frequenzbestimmenden Kapazität (1513) geschlossen ist,
    zudem mit einem zweiten Zeitglied (152), das wie das erste Zeitglied (151) aufgebaut ist, und einer Logik (153), die an das erste und zweite Zeitglied (151, 152) angeschlossen ist,
    wobei mit der Logik (153) abwechselnd die frequenzbestimmende Kapazität (1513) des ersten Zeitglieds (151) und eine frequenzbestimmende Kapazität (1523) des zweiten Zeitglieds (152) mit Hilfe eines Stroms bis zur Endspannung aufgeladen wird, und die Kapazität (1513, 1523) bei inaktivem Zeitglied (151, 152) vollständig entladen wird.

2. Oszillator (150) nach Anspruch 1,
wobei die schaltbare Kapazität (15147) auf die Spannungsdifferenz Endspannung ($U_{End}$) - Schwellwertspannung ($U_{TH}$) aufladbar ist, wenn der Schalter (15145) in der Offsetphase geschlossen ist.

3. Oszillator (150) nach einem der vorangehenden Ansprüche,

    zudem mit einem Schalter (1512) zum Kurzschließen der frequenzbestimmenden Kapazität (1513),
    wobei der Schalter (1512) in einer Offsetphase geschlossen und in einer Aufladephase der frequenzbestimmenden Kapazität (1513) geöffnet ist.

4. Oszillator (150) nach einem der vorangehenden Ansprüche,

    zudem mit einem Schalter (15148) zum Kurzschließen von Drain und Gate des MOS-Transistors (15142) des Komparators (1514), ,
    wobei der Schalter (15148) in einer Offsetphase geschlossen und in einer Aufladephase der frequenzbestimmenden Kapazität (1513) geöffnet ist.

**5.** Sende-/Empfangseinrichtung (12) für eine Teilnehmerstation (10; 30) für ein Bussystem (1),

wobei die Sende-/Empfangseinrichtung (12) zum Senden oder Empfangen einer Nachricht (45; 46; 47) von mindestens einer weiteren Teilnehmerstation des Bussystems (1) über das Bussystem (1), bei welchem Bussystem (1) zumindest zeitweise ein exklusiver, kollisionsfreier Zugriff einer Teilnehmerstation (10, 20, 30) auf einen Bus (40) des Bussystems (1) gewährleistet ist,
wobei die Sende-/Empfangseinrichtung (12) einen Oszillator (15; 150) nach einem der vorangehenden Ansprüche aufweist.

**6.** Bussystem (1), mit

einem Bus (40), und
mindestens zwei Teilnehmerstationen (10; 20; 30), welche über den Bus (4) derart miteinander verbunden sind, dass sie miteinander kommunizieren können,
wobei mindestens eine der mindestens zwei Teilnehmerstationen (10; 20; 30) eine Sende-/Empfangseinrichtung (12) nach Anspruch 5 aufweist.

**Claims**

**1.** Oscillator (150) for producing a clock frequency (f), comprising

a timer (151) that has a frequency-determining capacitor (1513) for determining the frequency of the clock frequency (f) and a comparator (1514),
wherein the comparator (1514) is configured to identify a threshold value voltage ($U_{TH}$) up to which the frequency-determining capacitor (1513) can be charged, and
wherein the comparator (1514) has a switchable capacitor (15147) for offset compensation,
wherein the comparator (1514) has a MOS transistor (15142) for identifying the threshold value voltage ($U_{TH}$), the gate of which transistor is connected to one end of the switchable capacitor (15147),
additionally comprising a switch (15145) for connecting a voltage source (15144) in order to supply the comparator (1514) with a final voltage ($U_{End}$),
wherein the voltage source (15144) is connected in parallel with the frequency-determining capacitor (1513) when the switch (15145) is closed in an offset phase, and
additionally comprising a switch (15146) for connecting the frequency-determining capacitor (1513) of the timer (151) in series with the switchable capacitor (15147),
wherein the switch (15146) is open in an offset phase and is closed in a charging phase of the frequency-determining capacitor (1513),
additionally comprising a second timer (152), which is designed like the first timer (151), and a logic unit (153) that is connected to the first and the second timer (151, 152),
wherein the logic unit (153) is used to alternately charge the frequency-determining capacitor (1513) of the first timer (151) and a frequency-determining capacitor (1523) of the second timer (152) to the final voltage with the aid of a current, and the capacitor (1513, 1523) is completely discharged if the timer (151, 152) is inactive.

**2.** Oscillator (150) according to Claim 1,
wherein the switchable capacitor (15147) can be charged to the voltage difference final voltage ($U_{End}$) - threshold value voltage ($U_{TH}$) when the switch (15145) is closed in the offset phase.

**3.** Oscillator (150) according to either of the preceding claims,

additionally comprising a switch (1512) for shorting the frequency-determining capacitor (1513), wherein the switch (1512) is closed in an offset phase and open in a charging phase of the frequency-determining capacitor (1513).

**4.** Oscillator (150) according to one of the preceding claims,

additionally comprising a switch (15148) for shorting the drain and the gate of the MOS transistor (15142) of the comparator (1514),
wherein the switch (15148) is closed in an offset phase and open in a charging phase of the frequency-determining capacitor (1513).

**5.** Transmission/reception device (12) for a subscriber station (10; 30) for a bus system (1),

wherein the transmission/reception device (12) is configured to transmit or receive a message (45; 46; 47) to/from at least one further subscriber station of the bus system (1) via the bus system (1), in which bus system (1) exclusive, collision-free access by a subscriber station (10, 20, 30) to a bus (40) of the bus system (1) is ensured at least at times,
wherein the transmission/reception device (12) has an oscillator (15; 150) according to one of the preceding claims.

6. Bus system (1), comprising

a bus (40), and
at least two subscriber stations (10; 20; 30) that are connected to one another via the bus (4) in such a way that they can communicate with one another,
wherein at least one of the at least two subscriber stations (10; 20; 30) has a transmission/reception device (12) according to Claim 5.

## Revendications

1. Oscillateur (150) destiné à générer une fréquence d'horloge (f), ledit oscillateur comprenant un élément de temporisation (151) qui comporte un condensateur de détermination de fréquence (1513) destiné à déterminer la fréquence d'horloge (f) et un comparateur (1514),

le comparateur (1514) étant conçu pour détecter une tension de seuil ($U_{TH}$) jusqu'à laquelle le condensateur de détermination de fréquence (1513) doit être chargé, et
le comparateur (1514) comportant un condensateur commutable (15147) destiné à compenser un décalage,
pour détecter la tension de seuil ($U_{TH}$) le comparateur (1514) comportant un transistor MOS (15142) dont la grille est reliée à une extrémité du condensateur commutable (15147),
ledit oscillateur comportant en outre un commutateur (15145) destiné à commuter une source de tension (15144) afin d'alimenter le comparateur (1514) avec une tension finale ($U_{End}$),
la source de tension (15144) étant commutée en parallèle avec le condensateur de détermination de fréquence (1513) lorsque le commutateur (15145) est fermé dans une phase décalée, et
ledit oscillateur comportant en outre un commutateur (15146) destiné à commuter le condensateur de détermination de fréquence (1513) de l'élément de temporisation (151) en série avec le condensateur commutable (15147),
le commutateur (15146) étant ouvert dans une phase de décalage et fermé dans une phase de charge du condensateur de détermination de fréquence (1513),
ledit oscillateur comportant en outre un deuxième élément de temporisation (152) qui a la même structure que le premier élément de temporisation (151), et
un élément logique (153) qui est raccordé aux premier et deuxième éléments de temporisation (151, 152),
l'élément logique (153) permettant de charger alternativement le condensateur de détermination de fréquence (1513) du premier élément de temporisation (151) et un condensateur de détermination de fréquence (1523) du deuxième élément de temporisation (152) à l'aide d'un courant jusqu'à la tension finale, et le condensateur (1513, 1523) étant complètement déchargé lorsque l'élément de temporisation (151, 152) est inactif.

2. Oscillateur (150) selon la revendication 1, le condensateur commutable (15147) pouvant être chargé à la différence de tension 'tension finale ($U_{End}$) - tension de seuil ($U_{TH}$)' lorsque le commutateur (15145) est fermé dans la phase de décalage.

3. Oscillateur (150) selon l'une des revendications précédentes,

lequel comprend en outre un commutateur (1512) destiné à court-circuiter le condensateur de détermination de fréquence (1513),
le commutateur (1512) étant fermé dans une phase de décalage et étant ouvert dans une phase de charge du condensateur de détermination de fréquence (1513).

4. Oscillateur (150) selon l'une des revendications précédentes,

lequel comprend en outre un commutateur (15148) destiné à court-circuiter le drain et la grille du transistor MOS (15142) du comparateur (1514),
le comparateur (15148) étant fermé dans une phase de décalage et étant ouvert dans une phase de charge du condensateur de détermination de fréquence (1513).

5. Dispositif émetteur/récepteur (12) destiné à une station périphérique (10 ; 30) d'un système de bus (1),

le dispositif émetteur/récepteur (12) étant destiné à envoyer ou recevoir un message (45 ; 46 ; 47) d'au moins une autre station périphérique du système de bus (1) par le biais du système de bus (1), le système de bus (1) garantissant au moins temporairement un accès exclusif et sans collision d'une station périphérique (10, 20, 30) à un bus (40) du système de bus (1),
le dispositif émetteur/récepteur (12) comportant un oscillateur (15 ; 150) selon l'une des revendications précédentes.

6. Système de bus (1), comprenant

un bus (40) et
au moins deux stations périphériques (10 ; 20 ; 30) qui sont reliées entre elles par le biais du bus (4) de façon à pouvoir communiquer avec l'une une autre,
au moins une des au moins deux stations périphériques (10 ; 20 ; 30) comportant un dispositif émetteur/récepteur (12) selon la revendication 5.

**Fig. 1**

Fig. 2

Fig. 3

**Fig. 4**

EP 3 114 767 B1

Fig. 5

EP 3 114 767 B1

Fig. 6

150

151

153

15141

15143

15142

1514

15148

$U_{TH}$

15147

1510

1511

15145

15146

1513

15144

1512

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7474163 B1